# EUROPÄISCHE PATENTSCHRIFT

(11) **EP 1 656 407 B1**
(45) Veröffentlichungstag und Bekanntmachung des Hinweises auf die Patenterteilung: **12.03.2008**
(21) Anmeldenummer: 04764022.2
(22) Anmeldetag: 12.08.2004
(51) Int. Cl.: C08G 61/00, H01L 51/30, C09D 5/24, H01B 1/12

(54) **KONJUGIERTE COPOLYMERE, DEREN DARSTELLUNG UND VERWENDUNG**
CONJUGATED COPOLYMERS, REPRESENTATION AND USE THEREOF
COPOLYMERES CONJUGUES, LEUR PREPARATION ET LEUR UTILISATION

(30) Priorität: 12.08.2003 DE 10337077
(43) Veröffentlichungstag der Anmeldung: 17.05.2006
(73) Patentinhaber: Merck Patent GmbH, 64293 Darmstadt (DE)
(72) Erfinder: BECKER, Heinrich, 65719 Hofheim (DE); BREUNING, Esther, 65527 Niedernhausen (DE); LUDEMANN, Aurélie, 60322 Frankfurt (DE); PARHAM, Amir, 65929 Frankfurt (DE)
(86) Internationale Anmeldenummer: PCT/EP2004/009018
(87) Internationale Veröffentlichungsnummer: WO 2005/014688

(56) Entgegenhaltungen:
- EP-A- 1 398 340
- WO-A-03/007395
- DE-A- 10 159 946
- GUNTNER R ET AL: "Conjugated polyfluorene/polyaniline block copolymers-improved synthesis and nanostructure formation" PREPARATION AND CHARACTERIZATION, ELSEVIER SEQUOIA, NL, Bd. 417, Nr. 1-2, 30. September 2002 (2002-09-30), Seiten 1-6, XP004387695 ISSN: 0040-6090
- CHEN X L ET AL: "BLOCK CONJUGATED COPOLYMERS: TOWARD QUANTUM-WELL NANOSTRUCTURES FOR EXPLORING SPATIAL CONFINEMENT EFFECTS ON ELECTRONIC, OPTOELECTRONIC AND OPTICAL PHENOMENA" MACROMOLECULES, AMERICAN CHEMICAL SOCIETY. EASTON, US, Bd. 29, Nr. 19, 1996, Seiten 6189-6192, XP001070717 ISSN: 0024-9297

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423283 (WO 90/13148) offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit Markt beherrschenden Flüssigkristallanzeigen (LCD) zu machen bzw. diese zu überflügeln. Vor allem ist es hierbei erforderlich, Polymere für alle Emissionsfarben (Rot, Grün, Blau) zur Verfügung zu stellen, die den Anforderungen des Marktes (Effizienz, operative Lebensdauer, Betriebsspannung, um die wichtigsten zu nennen) gerecht werden.

Als Polymere für vollfarbige Anzeigeelemente (sog. Full-Colour-Displays) wurden bereits verschiedene Materialklassen vorgeschlagen bzw. entwickelt. So kommen Polyfluoren-Derivate, wie beispielsweise in EP 0842208, WO 99/54385, WO 00/22027, WO 00/22026 und WO 00/46321 offenbart, in Betracht. Des Weiteren sind auch Polyspirobifluoren-Derivate, wie in EP 0707020, EP 0894107 und WO 03/020790 offenbart, eine Möglichkeit. Auch Polymere, die eine Kombination der beiden erstgenannten Strukturelemente enthalten, wie in WO 02/077060 offenbart, wurden bereits vorgeschlagen. Im Allgemeinen sind für derartigen Einsatz Polymere, welche Poly-para-phenylen (PPP) als Strukturelement enthalten, möglich. Neben den oben bereits genannten Klassen kommen hier beispielsweise auch die so genannten Leiter-PPPs ("Ladder-PPPs" = L-PPP) (z. B. gemäß WO 92/18552), die Poly-tetrahydropyrene (z. B. gemäß EP 699699), aber auch Ansa-Strukturen enthaltende PPPs (z. B. gemäß EP 690086) in Frage.

Wie in einigen der o. g. Anmeldeschriften bereits herausgearbeitet wurde, ist es für die Erzeugung aller drei Emissionsfarben notwendig, bestimmte Comonomere in die entsprechenden Polymere einzupolymerisieren (z. B. WO 00/46321, WO 03/020790 und WO 02/077060). So ist dann - ausgehend von einem blau emittierenden Polymergrundgerüst ("backbone") - die Erzeugung der beiden anderen Primärfarben Rot und Grün möglich.
Des Weiteren wurde berichtet, dass das Einfügen bestimmter Arylamino-Gruppierungen eine Verbesserung der Eigenschaften ergibt: WO 99/54385 und

DE 19846767 beschreiben Polyfluorene, deren Effizienz und Einsatzspannung verbessert werden können, indem Derivate von Triphenylamin, Tetraphenyl-p-diaminobenzol, Tetraphenyl-4,4'-diaminobiphenyl oder substituierte Diarylaminoeinheiten in die Hauptkette der entsprechenden Polymere mit einpolymerisiert werden. WO 01/66618 beschreibt Copolymere, welche neben Aryleinheiten auch spezielle Triarylamino- bzw. Tetraaryl-p-diaminoarylen-Einheiten in der Hauptkette enthalten. In der nicht offen gelegte Anmeldung DE 10304819.7 wird beschrieben, dass die Verwendung bestimmter Carbazoleinheiten in verringerter Betriebsspannung resultiert. Die nicht offen gelegte Anmeldung EP 03012409.3 beschreibt die Verwendung von Oligo-Triarylamin-Einheiten.

Trotz der in den o. g. Anmeldeschriften zitierten Fortschritte gibt es auf folgenden Feldern immer noch einen erheblichen Verbesserungsbedarf für entsprechende Materialien:
- Die operative Lebensdauer, v. a. bei blau emittierenden Polymeren, bedarf immer noch einer deutlichen Verbesserung, um diese für langlebige Anwendungen einsetzen zu können.
- Die Effizienz ist noch deutlich verbesserungsbedürftig. Dies ist vor allem für mobile Anwendungen von großer Bedeutung.
- Die Betriebsspannung muss noch weiter reduziert werden, damit für Anwendungen große Helligkeit bei ausreichend niedrigen Spannungen erzielt werden kann und somit eine höhere Leistungseffizienz erzielt wird. Dies ist von enormer Bedeutung, da somit einerseits gleiche Helligkeit bei geringerem Energieverbrauch erzielt werden kann, was vor allem bei mobilen Applikationen (Displays für Handys, Pager, PDA, etc.), die auf Batterien und Akkus angewiesen sind, sehr wichtig ist. Andererseits erhält man bei gleichem Energieverbrauch höhere Helligkeiten, was beispielsweise für Beleuchtungsanwendungen interessant sein kann.

Copolymere aus zwei oder mehr unterschiedlichen Monomeren können prinzipiell verschiedenartig aufgebaut sein:
- In alternierenden Copolymeren alternieren die beiden (oder auch drei oder mehr) Wiederholeinheiten.
- In statistischen Copolymeren ist die Sequenz der Bausteine durch die bei der Polymerisation vorhandenen statistischen Gesetzmäßigkeiten gegeben.
- In teilstatistischen Copolymeren im Sinne dieser Erfindung ist die Anordnung einer der Wiederholeinheiten definiert, während die anderen Wiederholeinheiten statistisch angeordnet sind. Solche Copolymere werden beispielsweise durch Reaktion eines Monomeren A mit zwei Monomeren B und B' erhalten, wobei sowohl B als auch B' nur mit A, nicht aber mit B oder B' reagieren kann.
- Block-Copolymere bestehen aus Blöcken von Homosequenzen bzw. aus Blöcken von definierten Sequenzen, die über die Enden miteinander verknüpft sind. Die Verknüpfung der Blöcke kann auch über mittelständige Kettenglieder erfolgen. In diesem Fall erhält man Pfropf-Copolymere.
- Es können in einem Polymer auch verschiedene dieser Strukturmerkmale kombiniert werden. So können beispielsweise Blöcke über statistische oder teilstatistische Sequenzen verknüpft werden ("tapered copolymer").

In WO 00/55927 werden Copolymere beschrieben, die aus zwei oder mehr Regionen im Polymergrundgerüst bestehen. Dabei dient die erste Region dem Transport negativer Ladungsträger, die zweite Region dem Transport positiver Ladungsträger, während in der dritten Region positive und negative Ladungsträger unter Erzeugung von Licht rekombinieren. Dabei bezeichnet der Begriff "Region" ein Segment der Polymerkette, das aus einem oder mehreren Monomeren bestehen kann. Die Anordnung und das Verhältnis der Monomere im Polymer sind so gewählt, dass sich die Bandlücken der einzelnen Regionen im Polymer unterscheiden. Es wird beschrieben, dass die einzelnen Komponenten in der Hauptkette, in der Seitenkette, als Block-Copolymere oder als statistische Polymere kombiniert werden können. Jedoch wird nur die Synthese statistischer oder alternierender Copolymere beschrieben, und in den Beispielen werden nur teilstatistische oder alternierende Copolymere, jedoch keine Block-Copolymere, vorgestellt. Es wird auch kein Vorzug von Block-Copolymeren gegenüber statistischen Polymeren erwähnt, so dass nicht offensichtlich ist, wie brauchbare Blockpolymere hergestellt werden könnten, und die Vermutung nahe liegt, dass Block-Copolymere hier nur zufällig aufgeführt sind.

EP 1149827 beschreibt Polyfluorene mit einer Blockstruktur der allgemeinen Zusammensetzung
Endcapper1-(Fluoren)ₘ-(L)ₚ-(Fluoren)ₙ-(M)ₛ-(Fluoren)ₒ-Endcapper2, wobei L und M beliebige aromatische Monomere darstellen, mit der Vorgabe, dass m+n+o ≥ 10 ist, dass p und s im Bereich von 0 bis 15 ist und dass mindestens einer der beiden Endcapper Ladungstransporteigenschaften zeigt. Besondere Vorzüge eines solchen Polymers mit blockartigen Unterstrukturen werden nicht genannt. Auch wird kein Beispiel für ein solches blockartiges Polymer aufgeführt, ebenso wenig eine Synthesemethode dafür, und als bevorzugte Strukturen werden Polymere genannt, in denen m, p, s und o = 0 ist, die also nur Fluoreneinheiten aufweisen und somit keine Block-Copolymere sind. Dies lässt vermuten, dass die blockartige Struktur hier nur zufällig aufgeführt ist. Insbesondere ist auch für den Fachmann nicht nachvollziehbar, wie sich solche Blockpolymere synthetisieren lassen, da Polykondensationsprozesse, wie sie für diese Art von Polymeren üblicherweise angewendet werden und auch in den Beispielen aufgeführt sind, immer zu Mischungen und nicht zu klar definierten Polymeren führen, die genau drei Oligofluoren-Segmente besitzen, die über zwei (oligo)aromatische Segmente verbrückt sind.

WO 02/088223 beschreibt die Synthese und Verwendung konjugierter Block-Copolymere, die zwei oder mehr Blöcke enthalten, die gleich oder verschieden sein können, die eine oder mehrere Wiederholeinheiten haben können und die direkt oder über eine Zwischeneinheit miteinander verbunden sein können.

WO 03/007395 beschreibt konjugierte Block-Copolymere, die aus einem Emitter-Block und mindestens einem weiteren Block, der ein Ladungstransport-Block oder ein Host-Polymer-Block sein kann, bestehen. Als Vorteile dieser Polymere wird angegeben, dass diese bessere Eigenschaften in Elektrolumineszenzvorrichtungen zeigen, verglichen mit statistischen Copolymeren oder Blends statistischer Polymere, insbesondere hinsichtlich der Helligkeit; der Leistungseffizienz und der Lebensdauer. Als Beispiele werden allerdings nur Polymere aufgeführt, deren Blöcke teilstatistisch oder alternierend sind. Homoblöcke oder statistische Abschnitte werden nicht vorgestellt. Vergleicht man die Block-Copolymere mit den in den Vergleichsbeispielen angegebenen teilstatistischen Polymeren, so scheinen die Block-Copolymere tatsächlich höhere Effizienz (1.3 cd/A @ 100 cd/m² vs. 0.4 cd/A @ 100 cd/m²) und längere Lebensdauer (50 h vs. < 1 min.) zu zeigen. Jedoch können diese hier gezeigten Daten nicht als signifikant gewertet werden, da zum Zeitpunkt der Erfindung bereits weitaus bessere Polymere, sowohl in Bezug auf die Effizienz, als auch in Bezug auf die Lebensdauer bekannt waren: S. J. M. O'Connor et al. (Proceedings of SPIE 2001, 4105, 9-17) geben beispielsweise für ein blaues Copolymer eine Effizienz von 1.43 cd/A bei 100 cd/m² und eine Lebensdauer von 1600 h bei 100 cd/m² an. Ein Vorteil durch die Einführung blockartiger Strukturen ist also nicht ersichtlich.

Die Eigenschaften der bekannten Polymere in Elektrolumineszenzvorrichtungen haben sich also, wie beschrieben, in den letzten Jahren deutlich weiter entwickelt. Wie aus der Beschreibung des Stands der Technik jedoch auch ersichtlich ist, besteht weiterhin ein großer Weiterentwicklungsbedarf auf dem Gebiet der lichtemittierenden Polymere, da insbesondere die operative Lebensdauer, v. a. für blau emittierende Polymere, die Effizienz und die Betriebsspannung noch nicht den Voraussetzungen genügen, um die Polymere in hochwertige Vollfarbdisplays einzubauen.

Wir haben nun überraschend gefunden, dass bestimmte konjugierte Polymere, in denen geordnete Blöcke mit Polymerabschnitten verknüpft sind, die nicht blockartig aufgebaut sind, deutliche Verbesserungen, gerade auf den o. g. Gebieten, d. h. der operativen Lebensdauer, der Effizienz und der Betriebsspannung, zeigen. Diese sind daher Gegenstand der vorliegenden Anmeldung.

Gegenstand der Erfindung sind konjugierte Copolymere, die mindestens eine blockartige Struktur enthalten, die mindestens eine der folgenden Eigenschaften a - e aufweist:
a) Ladungstransportblock (entweder für Lochtransport oder Elektronentransport), oder
b) Ladungsinjektionsblock (entweder für die Injektion positiver oder negativer Ladungen), oder
c) emittierender Block, oder
d) Block, der den Übergang von Singulett- zu Triplett-Excitonen erleichtert, oder
e) Polymergrundgerüstblock,
dadurch gekennzeichnet, dass diese blockartigen Strukturen durch statistische oder teilstatistische Polymerabschnitte verknüpft sind.

Auch wenn dies aus der obigen Beschreibung hervorgeht, sei hier nochmals explizit darauf verwiesen, dass die Copolymere auch mehrere verschiedene der oben und a) bis e) aufgeführten blockartigen Strukturen enthalten kann.

In einer bevorzugten Ausführungsform der Erfindung sind die statistischen bzw. teilstatistischen Polymerabschnitte aus mindestens vier unterschiedlichen Monomeren aufgebaut.

Unter einem Block im Sinne dieser Erfindung soll hier allgemein ein Polymerabschnitt verstanden werden, der eine definierte Monomersequenz aufweist. Dabei kann dieser Block entweder aus alternierenden Strukturen, im einfachsten Fall also A-B-A-B bei nur zwei unterschiedlichen Monomeren, aufgebaut sein, oder es kann sich um einen Homoblock handeln, der also nur aus einer Monomersorte besteht. Unter einem Block im Sinne dieser Erfindung soll hier also kein Polymerabschnitt verstanden werden, der statistische oder teilstatistische Monomersequenz aufweist.

In einer bevorzugten Ausführungsform der Erfindung weisen die Blöcke alternierende Sequenzen der Wiederholeinheiten auf.
In einer weiteren bevorzugten Ausführungsform der Erfindung weisen die Blöcke Homosequenzen auf.

Unter einem statistischen Polymerabschnitt im. Sinne dieser Erfindung soll ein Polymerabschnitt verstanden werden, in dem die Sequenz aller Bausteine durch die bei der Polymerisation vorhandenen statistischen Gesetzmäßigkeiten gegeben ist. Unter einem teilstatistischen Polymerabschnitt im Sinne dieser Erfindung soll ein Polymerabschitt verstanden werden, in dem die Anordnung einer der Wiederholeinheiten definiert ist, während die anderen Wiederholeinheiten statistisch angeordnet sind. Solche Abschnitte werden beispielsweise durch Reaktion eines Monomeren A mit zwei Monomeren B und B' erhalten, wenn sowohl B als auch B' nur mit A, nicht aber mit B oder B' reagieren kann.

Bevorzugt handelt es sich bei mindestens einem dieser Blöcke um einen Block, der den Lochtransport, den Elektronentransport, den Übergang von so genannten Singulett-Excitonen auf Triplett-Excitonen oder die Lichtemission ermöglicht. Dabei kann ein Block auch mehrere dieser Eigenschaften gleichzeitig erfüllen.

In einer besonders bevorzugten Ausführungsform enthält das Polymer Lochleiter-Homoblöcke.
In einer weiteren besonders bevorzugten Ausführungsform enthält das Polymer alternierende Lochleiter-Grundgerüst-Blöcke.
In einer weiteren besonders bevorzugten Ausführungsform enthält das Polymer Emitter-Homoblöcke.
In einer weiteren besonders bevorzugten Ausführungsform enthält das Polymer alternierende Emitter-Grundgerüst-Blöcke.
In einer weiteren besonders bevorzugten Ausführungsform enthält das Polymer mehrere Blöcke, die mehrere verschiedene blockartige Strukturen, zum Beispiel alternierende Lochleiter-Grundgerüst-Blöcke und alternierende Emitter-Grundgerüst-Blöcke, enthalten, die durch statistische oder teilstatistische Sequenzen oder einzelne Monomere verknüpft sind.
In einer weiteren besonders bevorzugten Ausführungsform enthält das Polymer mehrere verschiedene blockartige Strukturen, welche durch einen schrittweisen Aufbau direkt miteinander verknüft sind.

Der Anteil der Monomere, die im Polymer in Blöcken vorliegen, beträgt mindestens 1 mol%, bevorzugt mindestens 5 mol%, besonders bevorzugt mindestens 10 mol%.

Ein solcher Anteil hat sich insbesondere bei der Verwendung der Polymere als Elektrolumineszenzmaterialien als günstig erwiesen. Für andere Anwendungen kann jedoch auch ein deutlich höherer Anteil an Blöcken bevorzugt sein, beispielsweise ein Anteil von Ladungstransport-Blöcken von 50 mol% und mehr für die Verwendung des Polymers in organischen Feldeffekttransistoren (O-FETs).

Weiterhin werden besonders gute Ergebnisse erhalten, wenn die Blöcke ein Molekulargewicht M_{w} von 10³ - 3-10⁵ g/mol, bevorzugt von 3-10³ bis 10⁵ g/mol, besonders bevorzugt von 5-10³ bis 8·10⁴ g/mol aufweisen.

Der Anteil der Monomere, die im Polymer in statistischen oder teilstatistischen Abschnitten vorliegt, beträgt mindestens 1 mol%, bevorzugt mindestens 5 mol%, besonders bevorzugt mindestens 10 mol%, insbesondere mindestens 30 mol%.

Weiterhin enthalten die statistischen oder teilstatistischen Polymerabschnitte im Durchschnitt mindestens 2 Wiederholeinheiten, bevorzugt mindestens 5 Wiederholeinheiten, besonders bevorzugt mindestens 10 Wiederholeinheiten.

Ein konjugiertes Polymer im Sinne dieser Erfindung ist ein Polymer, das in der Hauptkette hauptsächlich sp²-hybridisierte Kohlenstoffatome, die auch durch entsprechende Heteroatome ersetzt sein können, enthält. Dies bedeutet im einfachsten Fall abwechselndes Vorliegen von Doppel- (oder auch Dreifach-) und Einfachbindungen in der Hauptkette. Hauptsächlich meint, dass natürlich auftretende Defekte, die zu Konjugationsunterbrechungen führen, den Begriff "konjugiertes Polymer" nicht entwerten. Im Sinne dieser Erfindung wird ebenfalls als konjugiert bezeichnet, wenn sich in der Hauptkette Arylamineinheiten und/oder bestimmte Heterocyclen (d. h. Konjugation über N-, O- oder S-Atome) und/oder metallorganische Komplexe (d. h. Konjugation über das Metallatom) befinden. Hingegen würden Einheiten wie beispielsweise einfache (Thio)Etherbrücken, Alkylenketten, Ester-, Amid- oder Imidverknüpfungen eindeutig als nicht konjugierte Segmente definiert.

Die erfindungsgemäßen Copolymere können verschiedene Strukturelemente enthalten. Dies sind u. a. solche, wie sie in den o. g. Patentanmeldungen bereits offenbart sind. Hier sei vor allem auch auf die relativ umfangreiche Auflistung in der oben schon erwähnten Anmeldeschrift WO 02/077060 verwiesen; diese wird via Zitat als Bestandteil der vorliegenden Erfindung betrachtet. Diese weiteren Struktureinheiten können beispielsweise aus den im Folgenden beschriebenen Klassen stammen:
1. Struktureinheiten, die das Polymergrundgerüst bilden, bzw. blau emittierende Einheiten:
- Hier sind zunächst Polyphenylene und Einheiten, die davon abgeleitete Strukturen bilden, zu nennen. Dies sind beispielsweise (jeweils substituierte oder unsubstituierte) meta- oder para-Phenylene, 1,4-Naphthylene, 9,10-Anthracenylene, 2,7-Phenanthrenylene, 2,7-(9,10-Dihydro)phenanthrenylene, 1,6- bzw. 2,7- bzw. 4,9-Pyrene oder 2,7-Tetrahydropyrene. Auch entsprechende heterocyclische "Poly-Arylen"-bildende Strukturen, wie beispielsweise Oxadiazolylen, 2,5-Thiophenylen, 2,5-Pyrrolylen, 2,5-Furanylen, 2,5-Pyridylen, 2,5-Pyrimidinylen, 3,6- bzw. 2,7-Carbazolylen oder 5,8-Chinolinylen kommen in Frage.
- Des Weiteren sind komplexere Einheiten, wie die o. g. Fluorene, Spiro-9,9'-bifluorene, mehrfach überbrückte Einheiten (z. B. kurze Teilsegmente der o. g. L-PPP-Polymere), aber auch "doppelte" Fluoren-Einheiten (cis- oder trans-Indenofluorene) möglich. Auch diese können substituiert bzw. unsubstituiert sein.
- Bevorzugte Einheiten sind Spiro-9,9'-bifluorene, Fluorene, Indenofluorene und Dihydrophenanthrene.

2. Struktureinheiten, die die Ladungsinjektions- bzw. Ladungstransporteigenschaften beeinflussen:
Dies kann sich sowohl auf die Elektroneninjektions- oder -transporteigenschaften (wie beispielsweise Oxadiazol-Einheiten) als auch auf die Lochinjektions- oder - transporteigenschaften (wie beispielsweise Triarylamin-Einheiten) beziehen. Hier sei nochmals auf die umfangreiche Auflistung derartiger Struktureinheiten in der oben zitierten Anmeldeschrift WO 02/077060 verwiesen. Ebenso kommen für diesen Zweck Naphthylarylamine (WO 04/037887) oder Carbazol-Einheiten (DE 10304819.7) in Frage.

3. Struktureinheiten, die die Farbe der Emission verschieben, damit auch die Bandlücke des Polymers verändern und somit in der Regel auch die Ladungsinjektions- bzw. -transporteigenschaften verändern:
- Hier sind beispielsweise heterocyclische Verbindungen, wie die in der o. g. Anmeldung WO 03/020790 unter den Formeln (XX) bis (XXXXVI) genannten Strukturen zu nennen.
- Des Weiteren sind hier aber auch Arylenvinylen- oder Arylenacetylen-Strukturen, wie substituierte oder unsubstituierte Stilbenylene, Tolanylene, Bisstyrylarylene, Bis(arylacetylen)-arylene zu nennen.
- Schließlich kann auch der Einbau von größeren aromatischen Einheiten, wie zum Beispiel Chrysenen, Naphthacenen, Pyrenen, Pentacenen, Perylenen oder Coronenen, den o. g. Effekt (Farbverschiebung) erzeugen.

4. Struktureinheiten, welche einen Transfer von so genannten Singulett-Excitonen zu Triplett-Excitonen ermöglichen und welche auch bei Raumtemperatur mit hoher Effizienz aus dem Triplettzustand Licht emittieren können:
- Hierunter sind nun zunächst vor allem Verbindungen zu verstehen, welche Schweratome enthalten, d. h. Atome aus dem Periodensystem der Elemente mit einer Ordnungszahl von mehr als 36.
- Besonders geeignet hierfür sind Verbindungen, welche d- und f-Übergangsmetalle enthalten, die die o. g. Bedingung erfüllen. Ganz besonders bevorzugt scheinen hier entsprechende Struktureinheiten, welche Elemente der Gruppe 8 bis 10 (d. h. Ru, Os, Rh, Ir, Pd, Pt) enthalten.
- Als Struktureinheiten für die erfindungsgemäßen Polymeren kommen hier nun z. B. verschiedene Komplexe, welche beispielsweise in den Anmeldeschriften WO 02/068435, DE 10116962, EP 1239526 und WO 04/026886 beschrieben sind, in Frage.
- Des Weiteren kann es hier sinnvoll sein, zusätzlich zu den oben genannten Verbindungen, die aus dem Triplett-Zustand Licht emittieren können, weitere Komponenten zu verwenden, die den Singulett-Triplett-Transfer erleichtern. Hierfür kommen beispielsweise Carbazole (DE 10304819.7) oder Carbazol-Dimere (DE 10328627.6) in Frage.
Eine Auswahl bevorzugter weiterer Einheiten der erfindungsgemäßen Polymere sind in der folgenden Übersicht aufgelistet. Dabei soll die Einfachbindung die Verknüpfung im Polymer symbolisieren. Sie deutet hier keine Methylgruppe an.

| | | |
|---|---|---|
| 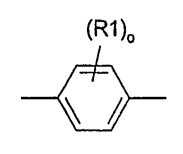 | 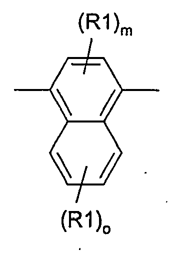 | 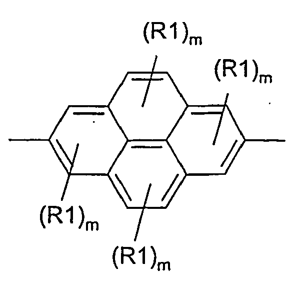 |
| 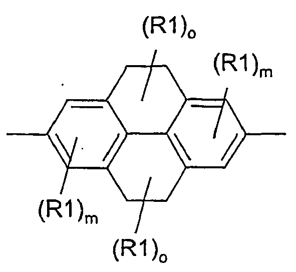 | 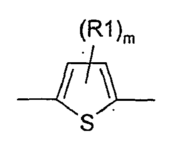 | 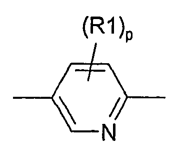 |
| 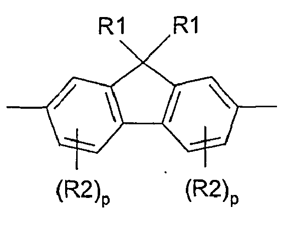 | 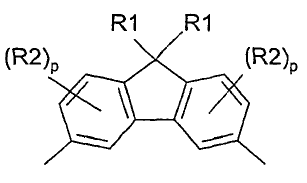 | 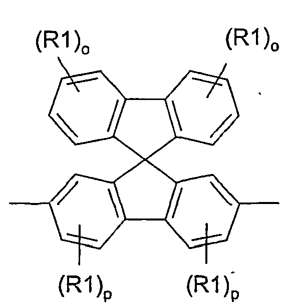 |
| 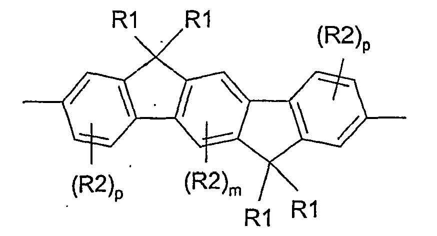 | | 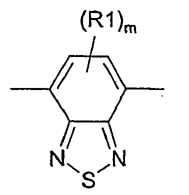 |
| 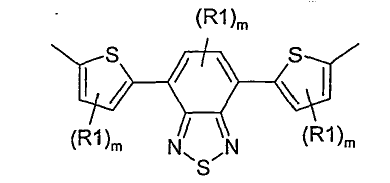 | | 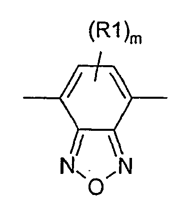 |
| 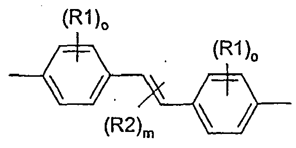 | 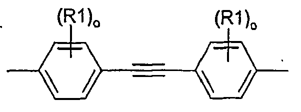 | 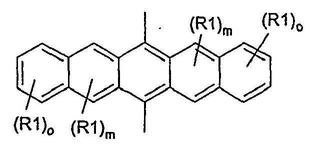 |
| 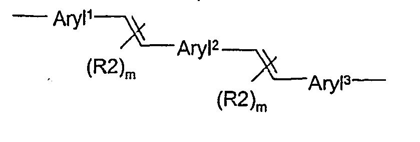 | | 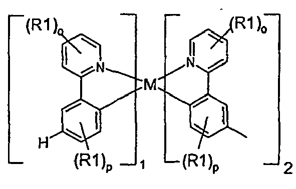 |
| 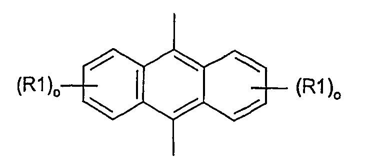 | | 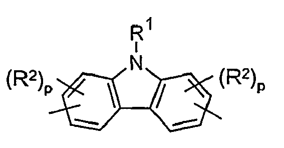 |

Dabei bedeuten die verwendeten Symbole R1, R2, Aryl¹, Aryl², Aryl³, M und Indizes m, o und p:
- Aryl¹, Aryl³: sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
- Aryl²: ist bei jedem Auftreten gleich oder verschieden Aryl¹, Aryl³ oder einer substituierten bzw. unsubstituierten Stilbenylen- bzw. Tolanyleneinheit;
- R1: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch NR2, O, S, CO-O, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch einen oder mehrere nicht-aromatische Reste R1 substituiert sein können, oder Cl, F, CN, N(R2)₂, B(R2)₂, wobei auch zwei oder mehrere Reste R1 miteinander ein Ringsystem bilden können;
- R2: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können.
- m: sind gleich oder verschieden bei jedem Auftreten 0, 1 oder 2;
- o: ist bei jedem Auftreten gleich oder verschieden 0, 1, 2, 3 oder 4;
- p: ist bei jedem Auftreten gleich oder verschieden 0, 1, 2 oder 3;
- M: ist bei jedem Auftreten gleich oder verschieden Rh oder Ir.

Die erfindungsgemäßen Polymere weisen in der Regel 10 bis 10000, bevorzugt 50 bis 5000, besonders bevorzugt 50 bis 2000 Wiederholeinheiten auf.

Die nötige Löslichkeit wird v. a. durch die Substituenten R1 erreicht. In der Regel ist es deshalb nötig, dass im Durchschnitt pro Wiederholeinheit mindestens 2 nicht-aromatische C-Atome in den Substituenten vorhanden sind. Bevorzugt sind mindestens 4, besonders bevorzugt mindestens 8 C-Atome. Einzelne dieser C-Atome können auch durch O oder S ersetzt sein. Dies schließt nicht aus, dass ein gewisser Anteil von Wiederholeinheiten keine weiteren nicht-aromatischen Substituenten trägt.
Um die Morphologie des Films nicht zu verschlechtern, ist es bevorzugt, keine langkettigen Substituenten mit mehr als 12 C-Atomen in einer linearen Kette zu haben, bevorzugt keine mit mehr als 8 C-Atomen, besonders bevorzugt keine mit mehr als 6 C-Atomen.
Nicht-aromatische C-Atome sind, wie in der Beschreibung für R1, in entsprechenden geradkettigen, verzweigten oder cyclischen Alkyl- oder Alkoxyketten enthalten.

Die erfindungsgemäßen Copolymere enthalten nun bevorzugt mindestens eine Sorte Blöcke mit alternierender Monomersequenz oder Homo-Sequenz, wobei es sich dabei um Blöcke handeln kann, die die Lochinjektion bzw. den Lochtransport, die Elektroneninjektion bzw. den Elektronentransport, den Übergang von so genannten Singulett-Excitonen auf Triplett-Excitonen oder die Lichtemission beeinflussen. Dabei kann ein Block auch mehrere Eigenschaften gleichzeitig erfüllen. Diese Blöcke definierter Sequenz sind durch Polymerabschnitte statistischer oder teilstatistischer Sequenz verknüpft. Durch das Verwenden sowohl definierter Blöcke wie auch statistischer Polymerabschnitte in demselben Copolymer können Eigenschaften wie Löslichkeit, Festphasenmorphologie, Ladungstransporteigenschaften, etc. eingestellt werden und damit die Emissionseigenschaften des Polymers deutlich verbessert werden. Dies ist insbesondere der Fall, wenn für die statistischen Polymerabschnitte vier und mehr unterschiedliche Monomere verwendet werden.
Besonders bevorzugte Copolymere enthalten mindestens eine Sorte eines Ladungstransport-Blocks, der entweder aus alternierenden Einheiten eines Polymer-Grundgerüsts mit einer Ladungstransporteinheit oder nur aus Ladungstransporteinheiten aufgebaut ist, wobei die Blöcke über statistische oder teilstatistische Abschnitte miteinander verknüpft sind. Das bevorzugte Molekulargewicht M_{w} der Blöcke liegt dabei im Bereich von 5.10³ - 8·10⁴.

Die erfindungsgemäßen Copolymere werden in der Regel durch Polymerisation von einem oder mehreren Monomeren hergestellt. Entsprechende Polymerisationsreaktionen, die sich hierfür eignen, gibt es prinzipiell relativ viele verschiedene; es haben sich jedoch die im Folgenden aufgeführten Polykondensationsreaktionen besonders bewährt. Grundsätzlich ergeben die Reaktionstypen (A) bis (C) C-C-Verknüpfungen, Reaktionstyp (D) ergibt C-N-Verknüpfungen:
(A) Polymerisation gemäß SUZUKI
(B) Polymerisation gemäß YAMAMOTO
(C) Polymerisation gemäß STILLE
(D) Polymerisation gemäß HARTWIG-BUCHWALD
Diese Methoden sind beispielsweise detailliert beschrieben in WO 03/048225 und WO 04/022626 und den darin zitierten Literaturstellen. Sie sind via Zitat Bestandteil dieser Anmeldung.

Die eigentliche Polymerisation (Polykondensation) (vgl. auch die Angaben bei den Beispielen) verläuft in zwei (oder mehr) Schritten. Zunächst wird in der Regel der Teil der Monomere, die den Block bilden sollen, in einem geeigneten Konzentrationsbereich in Lösung mit den entsprechenden Katalysatoren und Hilfssystemen zur Reaktion gebracht. Wird nur eine Sorte Wiederholeinheiten verwendet, werden dadurch Homoblöcke gebildet. Für eine alternierende Sequenz im Block kann man sich beispielsweise die charakteristische Eigenschaft der Polymerisationsverfahren (A), (C) und (D) zu Nutze machen, dass die Monomere nicht mit sich selbst, sondern nur mit Monomeren mit anderen funktionellen Gruppen reagieren können. Die Größe der Blöcke kann dabei beispielsweise durch Abweichung von der 1:1 1 Stöchiometrie der unterschiedlichen Monomere kontrolliert werden, aber auch durch die Reaktionszeit vor Zugabe der weiteren Monomere. Hat der Block die gewünschte Größe erreicht, werden die restlichen Monomere, gegebenenfalls zusammen mit weiterem Lösungsmittel, Katalysator und weiteren Hilfssystemen zugegeben, und die Polymerisation wird fortgeführt. Dabei kann es vorteilhaft sein, durch geringe Abweichungen von der idealen Stöchiometrie, bzw. durch das Vorhandensein geringer Mengen mono-funktioneller Verbindungen, eine Molekulargewichtsbegrenzung durchzuführen. Die Reaktion wird i. d. R. bis zum gewünschten Molekulargewicht durchgeführt (dabei kann beispielsweise Prozesskontrolle über Viskositätsmessung, etc. erfolgen). Man kann aber auch noch weitere, vom ersten unterschiedliche Blöcke aufbauen, die dann über die statistischen oder teilstatistischen Abschnitte verknüpft werden. Ebenso ist es möglich, die Polymerisation mit dem statistischen oder teilstatistischen Abschnitt zu beginnen und die Blöcke erst im Anschluss daran, wie oben beschrieben, aufzubauen. Des Weiteren ist ebenfalls möglich, sowohl die Blöcke als auch die statistischen oder teilstatistischen Abschnitte getrennt vorzupolymerisieren und anschließend das Polymer durch das Knüpfen weniger neuer Bindungen zwischen den Blöcken und den statistischen oder teilstatistischen Abschnitten weiter zu polymerisieren. Danach wird die Reaktion abgebrochen. Dies kann auf verschiedene Weise erfolgen. Um reaktive Endgruppen zu vermeiden, hat es sich bewährt, ein sogenanntes "Endcapping" durchzuführen, d. h. nach Erreichen des gewünschten Molekulargewichts monofunktionelle Verbindungen zuzugeben. Bei den Reaktionstypen A, C und D kann dies auch doppelt erfolgen, d. h. man gibt zunächst eine/mehrere monofunktionelle Verbindung(en) des einen Typs (z. B. Monohalogenid) und anschließend des anderen Typs (z. B. Monoboronsäurederivat) zu.

Danach müssen die synthetisierten Copolymere zunächst vom Reaktionsmedium abgetrennt werden. Die Isolierung und Aufreinigung der so erhaltenen Polymere ist bereits detailliert beispielsweise in WO 04/037887 beschrieben und wird an dieser Stelle nicht nochmals ausgeführt.

Um die erfindungsgemäßen Polymere beispielsweise durch die beschriebenen Verfahren herstellen zu können, werden die entsprechenden Monomere eingesetzt. Die Synthese, welche zu Strukturen führen, wie sie oben beschrieben wurden, ist in den bereits oben genannten Anmeldeschriften und Patenten ausführlich beschrieben. Einen guten Überblick hierzu gibt dabei die Anmeldeschrift WO 02/077060; die dort gemachten entsprechenden Ausführungen werden via Zitat als Bestandteil dieser Anmeldung betrachtet. Für Homo-Blöcke aus Triarylamin-Einheiten benötigt man für das Polymerisationsverfahren (A) außer den entsprechenden Dihalogeniden auch die entsprechenden Boronsäurederivate. Auch für die vollstatistischen Polymere werden von allen Monomeren sowohl die Halogenide wie auch die entsprechenden Boronsäurederivate benötigt.
- Boronsäurederivate von Triarylamin-Einheiten können beispielsweise durch Umsetzung der entsprechenden Dihalogenid-Verbindung mit einer Alkyllithium-Verbindung, gefolgt von Reaktion mit Triisopropylborat erhalten werden. Ebenso ist die Umsetzung zum Grignard-Reagens, gefolgt von Reaktion mit Trüsopropylborat, möglich.
- Eine andere Synthesemöglichkeit ist die Umsetzung der entsprechenden Dihalogenide mit Diboranen oder Boranen unter Palladium-Katalyse. Dies stellt eine gute Alternative zu obiger Synthese dar, wenn es sich um Substanzen handelt, die empfindlich gegenüber Basen sind und sich nicht oder nicht selektiv lithiieren oder zum Grignard-Reagens umsetzen lassen.
- Eine weitere Möglichkeit, die entsprechenden Boronsäurederivate zu erhalten, geht aus von primären oder sekundären Arylaminverbindungen. Diese können dann in einer HARTWIG-BUCHWALD-Kupplung unter dem Fachmann geläufigen Reaktionsbedingungen mit einer Aryl-monohalogenidmonoboronsäureester-Verbindung umgesetzt werden.
- Die so erhaltenen Boronsäuren oder Boronsäurederivate können gegebenenfalls durch Veresterung bzw. Umesterung weiter zu anderen Boronsäureestern umgesetzt werden. Dies kann für die Anwendung Vorteile bringen, da die Boronsäureester durch unterschiedliche Löslichkeitseigenschaften leichter aufgereinigt werden können. Außerdem ist von Interesse, dass unterschiedliche Boronsäureester unterschiedliche Stabilitäten und Reaktivitäten aufweisen.

Die direkte Umsetzung von primären oder sekundären Arylaminen mit Arylmonohalogenid-monoboronsäureester-Verbindungen, bei der die Halogenidfunktionalität unter Beibehaltung der Boronsäureesterfunktionalität reagiert, ist unerwartet und neu.
Gegenstand der Erfindung ist also auch ein Verfahren gemäß Formel (I) zur Herstellung von Aryl- oder (Heteroaryl)amin-Boronsäurederivaten durch HARTWIG-BUCHWALD-Kupplung eines primären oder sekundären Amins in Gegenwart einer Palladiumverbindung, mindestens eines Phosphinliganden und einer Base, dadurch gekennzeichnet, dass die Reaktion mit einer Aryl- oder Heteroaryl-monohalogenidmonoboronsäureester-Verbindung bzw. mit einer Aryl- oder Heteroarylmonosulfonat-monoboronsäureester-Verbindung durchgeführt wird: 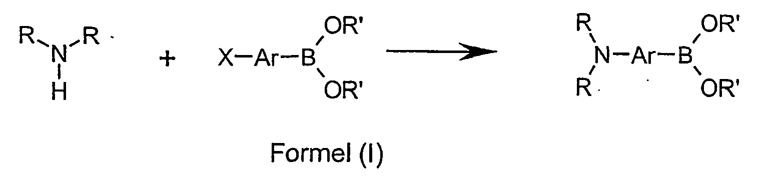 wobei für die verwendeten Symbole gilt:
- R: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R", O, S, CO-O, O-CO-O ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch einen oder mehrere nicht-aromatische Reste R substituiert sein kann, wobei auch zwei oder mehrere der Reste R miteinander ein Ringsystem bilden können, mit der Maßgabe, dass mindestens einer der Reste R an der Ausgangsverbindung ungleich H ist;
- R': ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch einen oder mehrere nicht-aromatische Reste R substituiert sein kann, wobei auch ein oder mehrere Reste R' miteinander ein Ringsystem bilden können;
- X: ist bei jedem Auftreten gleich oder verschieden Cl, Br, I oder O-SO₂R', mit der Vorgabe, dass R' hier ungleich H ist;
- Ar: ist bei jedem Auftreten gleich oder verschieden eine Arylen- oder Heteroarylengruppe mit 5 bis 40 C-Atomen, bei der auch ein oder mehrere C-Atome durch O, S oder N ersetzt sein können, welche auch durch einen oder mehrere Reste R' substituiert sein kann.

Diese Synthese gemäß Formel (I) lässt sich beispielsweise einsetzen für die Synthese von Boronsäureester-substituiertem Tetraphenylbenzidin, wie in Formel (II) dargestellt:

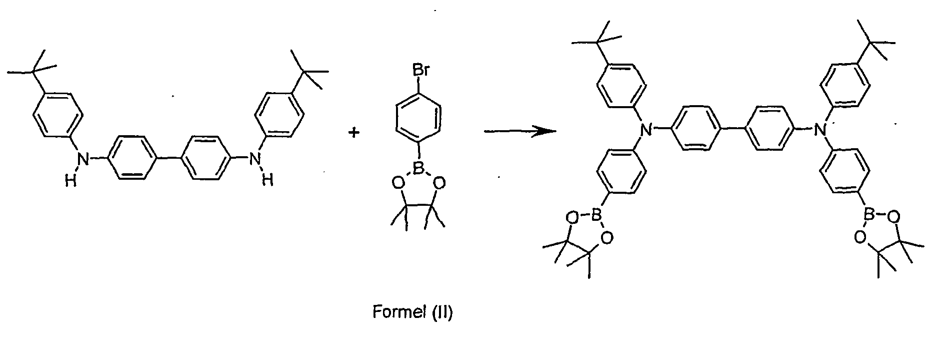

Es kann außerdem auch bevorzugt sein, das erfindungsgemäße Copolymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern, den Transfer vom Singulett- zum Triplettzustand beeinflussen oder selber emittieren. Aber auch elektronisch inaktive Substanzen können sinnvoll sein, um beispielsweise die Morphologie des gebildeten Polymerfilms oder die Viskosität von Polymerlösungen zu beeinflussen. Solche Blends sind daher auch Bestandteil der vorliegenden Erfindung.

Gegenstand der Erfindung sind weiterhin Lösungen von einem oder mehreren erfindungsgemäßen Polymeren oder Blends in einem oder mehreren Lösungsmitteln. Wie Polymerlösungen hergestellt werden können, ist beispielsweise beschrieben in WO 02/072714, in WO 03/019694 und der darin zitierten Literatur. Diese Lösungen können dann verwendet werden, um dünne Polymerschichten herzustellen, zum Beispiel durch Flächenbeschichtungsverfahren (z. B. Spincoating) oder durch Druckverfahren (z. B. InkJet Printing).

Die erfindungsgemäßen Polymere weisen nun gegenüber dem o. g. Stand der Technik u. a. folgende überraschende Vorteile auf:
- Die operative Lebensdauer bei der Verwendung in PLEDs ist bei vergleichbaren Polymeren deutlich erhöht (vgl. Angaben in Tabelle 1). Dies ist vor allem der Fall, wenn Ladungstransport-Homoblöcke verwendet werden. Dies bringt für die Anwendung deutliche Vorteile, da somit das Ziel, langlebige Vollfarbdisplays zu erzeugen, näher gerückt ist.
- Die Effizienz kann bei vergleichbaren Polymeren deutlich erhöht werden, wenn diese sowohl geordnete Blöcke wie auch statistische oder teilstatistische Abschnitte mit mindestens vier unterschiedlichen Monomeren enthalten. Dieser Effekt ist ebenfalls bei Ladungstransport-Homoblöcken besonders ausgeprägt.
   Dies ist den Angaben in Tabelle 1 zu entnehmen.
- Die Betriebsspannung bei der Verwendung in PLEDs kann deutlich gesenkt werden, wenn das Polymer geeignete Ladungstransport-Blöcke enthält. Hier sind die Ergebnisse besonders gut, wenn im Block die Ladungstransport-Einheiten mit Polymergrundgerüstbausteinen alternieren.
- Entsprechende Copolymere können so aufgebaut werden, dass diese alle Grundfarben (Rot, Grün, Blau) emittieren können.
- Die Löslichkeit in organischen Lösemitteln ist in der Regel gut, d. h. in Lösemitteln wie Toluol, Xylol, Anisol, Methylanisol, Methylnaphthalin sind die Polymere in Mengen im Bereich von 1 bis ca. 30 g/L (je nach Art des Blocks und Molekulargewicht des Polymers) löslich.

Die letzten beiden Punkte bringen zwar keine Verbesserung gegenüber bekannten Materialien, jedoch ist es essentiell, dass diese Eigenschaften auch bei erfindungsgemäßen Polymeren erhalten bleiben.

Die erfindungsgemäßen Copolymere können nun in PLEDs verwendet werden. Wie PLEDs hergestellt werden können, wird als allgemeines Verfahren ausführlich in WO 04/037887 beschrieben, das entsprechend für den Einzelfall anzupassen ist. Wie oben beschrieben, eignen sich die erfindungsgemäßen Copolymere ganz besonders als Elektrolumineszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht), und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Copolymers in organischen elektronischen Vorrichtungen, z. B. in polymeren Leuchtdioden (PLEDs), organischen Feld-Effekt-Transistoren (O-FET), organischen integrierten Schaltungen (O-IC), organischen Dünnfilmtransistoren (O-TFT), organischen Solarzellen (O-SC), organischen Laserdioden (O-Laser) und für die nicht-lineare Optik, aber insbesondere als Elektrolumineszenzmaterial.

Gegenstand der Erfindung ist somit ebenfalls eine elektronische Vorrichtung, z. B. polymere Leuchtdioden (PLEDs), organische Feld-Effekt-Transistoren (O-FET), organische integrierte Schaltungen (O-IC), organische Dünnfilmtransistoren (O-TFT), organische Solarzellen (O-SC), organische Laserdioden (O-Laser) und Vorrichtungen für die nicht-lineare Optik, insbesondere aber polymere Leuchtdioden (PLEDs), mit einer oder mehreren aktiven Schichten, wobei mindestens eine dieser aktiven Schichten ein oder mehrere erfindungsgemäße Copolymere enthält. Die aktive Schicht kann beispielsweise eine lichtemittierende Schicht und/oder eine Ladungstransportschicht und/oder eine Ladungsinjektionsschicht sein.

Im vorliegenden Anmeldetext und auch in den im Weiteren folgenden Beispielen wird hauptsächlich auf die Verwendung erfindungsgemäßer Copolymere in Bezug auf PLEDs und den entsprechenden Displays abgezielt. Trotz dieser Beschränkung der Beschreibung ist es für den Fachmann ohne weiteres erfinderisches Zutun möglich, die erfindungsgemäßen Polymere auch für weitere Verwendungen in anderen elektronischen Devices (Vorrichtungen) zu benutzen, z. B. O-ICs, OFETs, OTFTs, O-SCs, O-Laser oder auch nicht-lineare Optik, um nur einige Anwendungen zu nennen. Gerade für O-ICs und OFETs können entsprechende erfindungsgemäße Copolymere, welche einen relativ hohen Anteil an Ladungstransport-Homoblöcken oder alternierenden Ladungstransport-Blöcken aufweisen, Verwendung finden.

Die Erfindung wird durch die nachfolgenden Beispiele näher erläutert, ohne sie dadurch einschränken zu wollen.

### Beispiele

### Teil A: Synthese der Monomere

### A1: Synthese von Boronester-Monomeren (benötigt für die Synthese von Blöcken oder statistischen Polymeren)

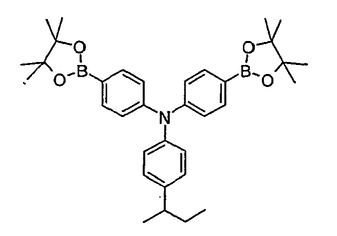

### A1.1 Synthese N,N-Bis-(4-boronsäurepinakolester)phenyl-N-(4-tert-butylphenyl)amin (BOR1)

In einem ausgeheizten 5L Vierhalskolben mit mechanischem Rührer, Stickstoffanschluss, Tropftrichter und Tieftemperaturthermometer wurden 150 g (327 mmol) Monomer **M11** (substituiert mit einer sec-Butylgruppe) in 2.5 L trockenem THF gelöst und auf -78 °C gekühlt. 390 mL (975 mmol) Butyllithium (2.5 molare Lösung in Hexan) wurden so zu der Reaktionsmischung getropft, dass die Innentemperatur-70 °C nicht überstieg. Nach Beendigung der Zugabe wurde weitere 45 Minuten bei -78 °C gerührt. Dann wurden 230 mL (991 mmol) Triisopropylborat tropfenweise so zugegeben, dass die Innentemperatur-70 °C nicht überstieg. Es wurde noch weitere 4 h bei -78 °C gerührt, dann wurden 500 mL HCl (2 molare Lösung in Diethylether) bei -70 °C zugegeben, und man ließ die Mischung auf Raumtemperatur kommen. Das Produkt wurde im Vakuum eingeengt. Der Rückstand wurde in 1 L Toluol aufgenommen und das ausgefallene LiBr abfiltriert. 112 g (950 mmol) Pinakol und 1 g para-Toluolsulfonsäure wurden zugegeben, und die Reaktionsmischung wurde 2 h am Wasserabscheider unter Rückfluss erhitzt. Nach Abkühlen auf Raumtemperatur wurden 3 g Kaliumcarbonat zugegeben, die Mischung wurde filtriert und im Vakuum eingeengt. Das Produkt wurde mit 200 mL Ethylacetat 1 h ausgerührt, filtriert und über Nacht bei 40 °C unter Vakuum getrocknet. Das reine Produkt wurde durch wiederholte Umkristallisation aus Ethylacetat gewonnen. Es wurden 45.2 g (25 % d. Th.) des Produktes in einer Reinheit von 100 % (nach HPLC und GC/MS) erhalten.
¹H-NMR (500 MHz, CDCl₃): 0.84 (t, J = 7.4 Hz, 3H, CH₃), 1.23 (d, J = 7 Hz, 3H, CH₃), 1.33 (s, 24H, Pinakol) 1.57 (m, 2H, CH₂), 2.57 (m, 1 H, CH), 7.04 (m, 8H, Phenylen), 7.66 (m, 4H, Phenylen).

### A1.2 Synthese von Monomer BOR2

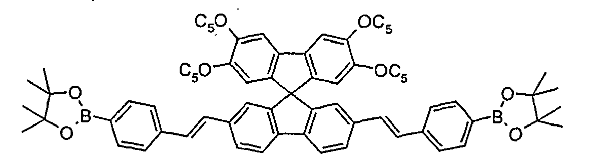

20.46 g (20 mmol) Monomer **M19** wurden in 520 mL Dioxan vorgelegt. Es wurden 20 mL (144 mmol) Triethylamin, 9.9 mL (68 mmol) Pinakolboran und anschließend 1 g (1.36 mmol) [1,1-Bis(diphenylphosphino)ferrocen]palladium(II)-chlorid zugegeben und der Ansatz wurde unter Argon 72 h auf 80 °C erhitzt. Das Dioxan wurde unter Vakuum entfernt. Der Rückstand wurde in 500 mL Ethylacetat und 500 mL Wasser aufgenommen und filtriert. Die Phasen wurden getrennt, und die wässrige Phase wurde mit 3 x 150 mL Ethylacetat extrahiert. Die vereinigten organischen Phasen wurden über MgSO₄ getrocknet und das Lösungsmittel wurde im Vakuum entfernt. Das Rohprodukt wurde mit Hexan ausgerührt, filtriert und getrocknet. Weitere Reinigung erfolgte durch wiederholte Umkristallisation aus Dioxan. Es wurden 9.37 g (42 % d. Th.) Produkt in einer Reinheit von 99.7 % (nach HPLC) erhalten.
¹H-NMR (CDCl₃, 500 MHz): 0.86 (t, ³J_{HH} = 7.5 Hz, 6H, CH₃), 0.93 (d, ³J_{HH} = 9.7 Hz, 6H, CH₃), 0.99 (t, ³J_{HH} = 7.3 Hz, 6H, CH₃), 1.09 (d, ³J_{HH} = 6.7 Hz, 6H, CH₃), 1.18 (m, 2H, CH₂), 1.34 (m, 2H, CH₂), 1.36 (s, 24H, CH₃), 1.48 (m, 2H, CH), 1.64 (m, 2H, CH), 1.75 (m, 2H, CH₂), 1.95 (m, 2H, CH₂), 3.55 (m, 4H, CH₂), 3.95 (m, 4H, CH₂), 6.20 (s, 2H, Spiro), 6.88 (s, 2H, Spiro), 6.91 (2 d, ³J_{HH} = 16.1 Hz, 4H, Olefin), 7.26 (m, 2H, Spiro), 7.72 (d, ³J_{HH} = 9.0 Hz, 4H, Phenylen), 7.49 (dd, ³J_{HH} = 8.0 Hz, ⁴J_{HH} = 1.4 Hz, 2H, Spiro), 7.55 (d, ³J_{HH} = 8.9 Hz, 4H, Phenylen), 7.78 (d, ³J_{HH} = 7.7 Hz, 2H, Spiro).

### A1.3 Synthese von N,N'-Bis-(4-boronsäurepinakolester)phenyl-N,N'-bis-(4-tert-butylphenyl)-biphenyl-4,4'-diamin (BOR3)

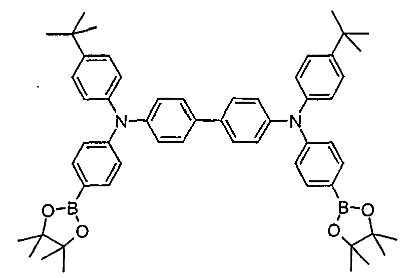

Eine entgaste Lösung von 8.75 g (19.5 mmol) N,N'-Bis-(4-tert-butylphenyl)-biphenyl-4,4'-diamin und 12.11g (42.8 mmol) 1-Brom-4-(pinakolboran)benzol in 500 mL Toluol wurde 1 h lang mit N₂ gesättigt. Dann wurde die Lösung mit 157.8 mg (0.78 mmol) P(^{t}Bu)₃ und 87.6 mg (0.39 mmol) Pd(OAc)₂ versetzt, anschließend wurden 4.84 g (50.4 mmol) NaO^{t}Bu im festen Zustand zugegeben. Die Reaktionsmischung wurde 4 h unter Rückfluss erhifizt. Nach Abkühlen auf Raumtemperatur wurden vorsichtig 153 mg NaCN und 10 mL Wasser zugesetzt. Die organische Phase wurde mit 4 x 50 mL H₂O gewaschen, über MgSO₄ getrocknet und die Lösungsmittel in Vakuum entfernt. Das reine Produkt erhielt man durch Umkristallisation aus Dioxan. Die Ausbeute betrug 6.6 g (40 % d. Th.), die Reinheit 99.8 % (nach HPLC).
¹H-NMR (CDCl₃, 500 MHz): 1.32 (s, 18H), 1.33 (s, 24H), 7.05 (d, J = 8.7 Hz, 8H), 7.13 (d, J = 8.7 Hz, 4H), 7.27 (d, J = 8.4 Hz, 4H), 7.45 (d, J = 8.4 Hz, 4H),), 7.66 (d, J = 8.7Hz, 4H).

### A2: Monomere für weitere Einheiten

Die Synthese der weiteren Monomere **M1** bis **M23** ist bereits in WO 02/077060 und der darin zitierten Literatur ausführlich beschrieben worden. Die Monomere sind zur besseren Übersicht im Folgenden nochmals dargestellt:

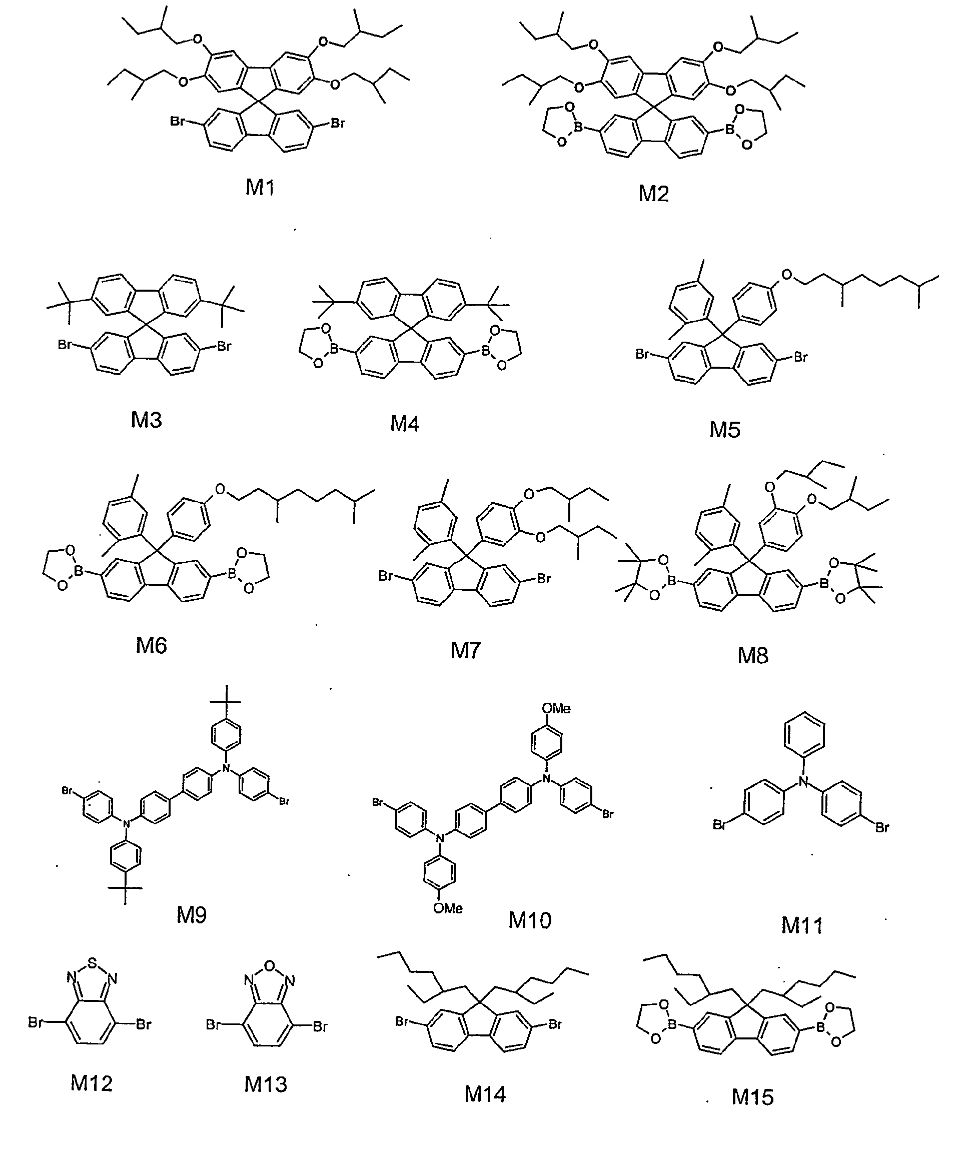

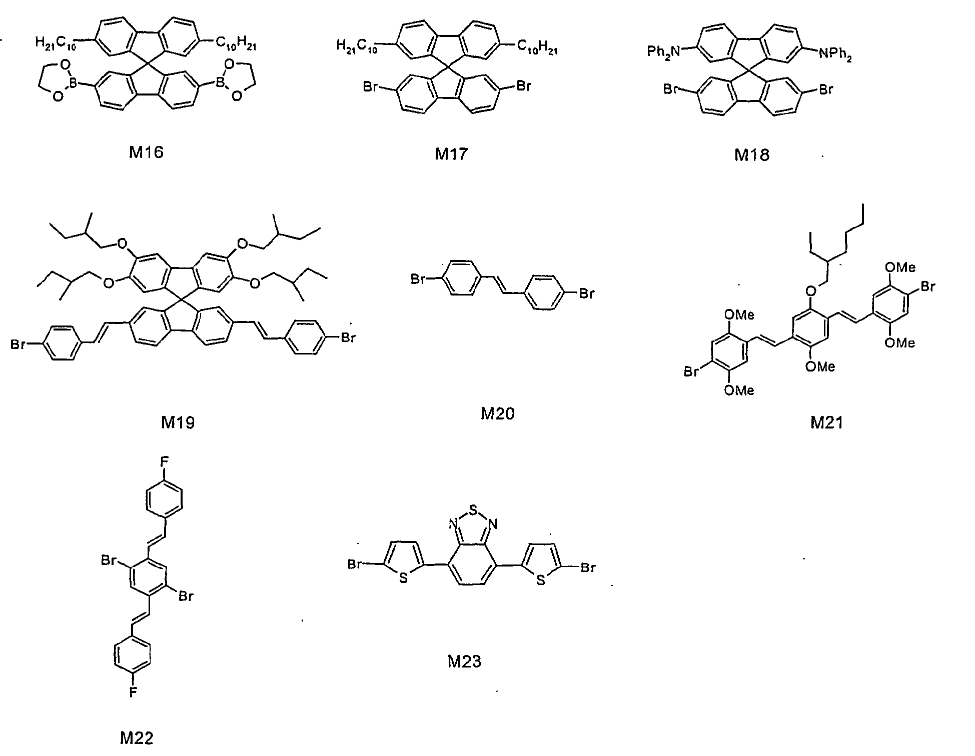

### Teil B: Herstellung der Polymere

### Synthese von Polymer P1:

### Polymer mit alternierendem Lochleiter-Grundgerüst-Block, verknüpft mit statistischen Emitter-Grundgerüst-Abschnitten

0.6069 g (0.8 mmol) Monomer **M9,** 0.5765 g (0.72 mmol) Monomer **M2** und 3.91 g Kaliumphosphat-Hydrat wurden gelöst in 25 mL Toluol, 25 mL Dioxan und 6.8 mL Wasser (alle Lösungsmittel sauerstofffrei). Die Reaktionslösung wurde 30 Minuten mit Argon entgast. Dann wurden 0.45 mg Pd(OAc)₂ und 3.65 mg P(o-tolyl)₃ als Katalysator zugegeben, und die Lösung wurde 4 h unter Rückfluss unter einer Argon-Atmosphäre erhitzt. Für den Block wurde ein Molekulargewicht von Mₙ = 13.7 kDa und M_{w} = 34.4 kDa bestimmt. Anschließend wurden 0.8118 g (1.2 mmol) Monomer **M7,** 0.9248 g (1.2 mmol) Monomer **M8, 1.6333** g (2.04 mmol) Monomer **M2,** 0.9825 g (1.2 mmol) Monomer **M1** und 0.8185 g (0.8 mmol) Monomer **M19** zugegeben, und die Mischung wurde weitere 5 h unter Rückfluss erhitzt. Dann wurde das Endcapping durchgeführt, indem 0.1 mL Brombenzol und 50 mL Toluol zugegeben wurden, dann wurde 1 h unter Rückfluss erhitzt, 200 mg Benzolboronsäure und 40 mL Toluol zugegeben und 1 h unter Rückfluss erhitzt. Die Polymerlösung wurde mit 100 mL Toluol verdünnt und bei 60 °C mit 100 mL 0,01 %iger wässriger NaCN-Lösung 3 h ausgerührt. Dann wurden die Phasen getrennt und die organische Phase mit 4 x 100 mL H₂O gewaschen. Das Polymer wurde durch Eintropfen in das doppelte Volumen an Methanol ausgefällt und filtriert. Weitere Reinigung erfolgte durch Lösen in 500 mL THF bei 60 °C unter Argon, Filtration über Celit und erneute Fällung durch Zugabe des doppelten Volumens Methanol. Das Polymer wurde filtriert und unter Vakuum getrocknet. Es wurden 4.66 g (93 % d. Th.) Polymer isoliert, M_{w} = 993 kDa, Mₙ = 200 kDa, Polydispersität = 5.0.

### Synthese von Polymer P2:

### Polymer mit alternierendem Lochleiter-Grundgerüst-Block, verknüpft mit teilstatistischen Emitter-Grundgerüst-Abschnitten

Synthese analog zu **P1** mit 1.214 g (1.6 mmol) Monomer **M9**, 1.153 g (1.44 mmol) Monomer **M2** und 4.05 g Kaliumphosphat-Hydrat in 25 mL Dioxan, 25 mL Toluol und 7 mL Wasser für den Block und 1.4091 g (1.67 mmol) Monomer **M2,** 0.5415 g (0.8 mmol) Monomer **M7,** 0.6165 g (0.8 mmol) Monomer **M8**, 0.6550 g (0.8 mmol) Monomer **M1** und 0.819 g (0.8 mmol) Monomer **M19** und 10 mL Dioxan/Toluol (1:1) für den statistischen Abschnitt. Ausbeute: 4.55 g (90 % d. Th.). Mₙ = 91 kDa, M_{w} = 392 kDa, Polydispersität 4.3. Molekulargewicht des Blocks: Mₙ = 10.2 kDa, M_{w} = 27.8 kDa.

### Synthese von Polymer P3:

### Polymer mit Lochleiter-Homoblock, verknüpft mit statistischen Emitter-Backbone-Abschnitten

Synthese analog zu **P1** mit 0.2021 g (0.44 mmol) **M11** (substituiert in 4-Position des nicht bromierten Phenylrings mit einer sec-Butylgruppe), 0.1992 g (0.36 mmol) Monomer **BOR1** und 4.05 g Kaliumphosphat-Hydrat in 2.5 mL Dioxan, 2.5 mL Toluol und 20 mL Wasser für den Block und 1.624 g (2.4 mmol) Monomer **M7**, 0.295 g (0.36 mmol) Monomer **M1,** 2.914 g (3.64 mmol) Monomer **M2** und 0.818 g (0.8 mmol) Monomer **M19** in 22.5 mL Dioxan und 22.5 mL Toluol für die teilstatistischen Abschnitte. Ausbeute: 4.56 g (92 % d. Th.). Mₙ = 96 kDa; M_{w} = 361 kDa; Polydispersität = 3.7.

### Synthese von Polymer P4:

### Polymer mit Lochleiter-Homoblock, verknüpft mit statistischen Emitter-Backbone-Abschnitten

Synthese analog zu **P1** mit 0.1947 g (0.42 mmol) Monomer **M11** (substituiert in 4-Position des nicht bromierten Phenylrings mit einer sec-Butylgruppe), 0.2081 g (0.34 mmol) Monomer **BOR1** und 4.05 g Kaliumphosphat-Hydrat in 2.5 mL Dioxan, 2.5 mL Toluol und 20 mL Wasser für den Block und 1.6309 g (1.99 mmol) Monomer **M1**, 1.6077 g (2.01 mmol) Monomer **M2,** 0.8064 g (1.19 mmol) Monomer **M7,** 0.9310 g (1.21 mmol) Monomer **M8**, 0.4010 g (0.39 mmol) Monomer **M19** und 0.4558 g (0.41 mmol) Monomer **BOR2** in 22.5 mL Dioxan und 22.5 mL Toluol für die vollstatistischen Abschnitte. Ausbeute: 4.18 g Polymer (87 % d. Th.). Mₙ = 78 kDa; M_{w} = 304 kDa; Polydispersität = 3.9.

### Synthese von Polymer P5:

### Polymer mit alternierendem Lochleiter-Grundgerüst-Block, verknüpft mit teilstatistischen Emitter-Grundgerüst-Abschnitten

Synthese analog zu **P1** mit 0.6069 g (0.8 mmol) Monomer **M9**, 0.6085 g (0.76 mmol) Monomer **M2** und 4.05 g Kaliumphosphat-Hydrat in 5 mL Toluol, 5 mL Dioxan und 20 mL Wasser für den Block und 1.1496 g (1.6 mmol) Monomer **M21,** 2.5749 g (3.21 mmol) Monomer **M2** und 1.0825 g (1.6 mmol) Monomer **M7** in 15 mL Dioxan und 15 mL Toluol für die teilstatistischen Abschnitte. Ausbeute: 4.62 g (96 % d. Th.) Polymer isoliert. M_{w} = 297 kDa, Mₙ = 72 kDa, Polydispersität = 4.1. Molekulargewicht des Blocks: Mₙ = 30.3 kDa, M_{w} = 83.6 kDa.

### Synthese von Polymer P6:

### Polymer mit Lochleiter-Homoblock, verknüpft mit teilstatistischen Emitter-Backbone-Abschnitten

Synthese analog zu **P1** mit 0.2021 g (0.44 mmol) **M11** (substituiert in 4-Position des nicht-bromierten Phenylrings mit einer sec-Butylgruppe), 0.1992 g (0.36 mmol) Monomer **BOR1** und 4.05 g Kaliumphosphat-Hydrat in 2.5 mL Dioxan, 2.5 mL Toluol und 20 mL Wasser für den Block und 1.082 g (1.6 mmol) Monomer **M7,** 0.295 g (0.36 mmol) Monomer **M1,** 2.914 g (3.64 mmol) Monomer **M2** und 1.149 g (1.6 mmol) Monomer **M21** in 17.5 mL Dioxan und 17.5 mL Toluol für den teilstatistischen Abschnitt. Ausbeute: 4.5 g Polymer (98 % d. Th.). Mₙ = 70 kDa; M_{w} = 296 kDa; Polydispersität = 4.2.

### Synthese von Polymer P7:

### Polymer mit alternierendem Lochleiter-Grundgerüst-Block, verknüpft mit teilstatistischen Emitter-Grundgerüst-Abschnitten

Synthese analog zu **P1** mit 0.6069 g (0.8 mmol) Monomer **M9,** 0.6085 g (0.76 mmol) Monomer **M2** und 4.05 g Kaliumphosphat-Hydrat in 2.5 mL Toluol, 7.5 mL Dioxan und 20 mL Wasser für den Block und 0.1833 g (0.4 mmol) Monomer **M23,** 0.8231 g (2.8 mmol) Monomer **M12** und 2.5941 g (3.24 mmol) Monomer **M2** in 22.5 mL Dioxan und 7.5 mL Toluol für die teilstatistischen Abschnitte. Ausbeute: 3.40 g (92 % d. Th.); M_{w} = 149 kDa, Mₙ = 53 kDa, Polydispersität = 2.8. Molekulargewicht des Blocks: Mₙ = 30.0 kDa, M_{w} = 79.4 kDa.

Weitere Polymere wurden analog den Beschreibungen für **P1** bis **P7** dargestellt. Die chemischen Eigenschaften sind in Tabelle 1 zusammengefasst. Es wurden nach analoger Methode auch einige Vergleichspolymere (in der Tabelle als **"V"** abgekürzt) dargestellt, die keine Blöcke enthalten und die entweder teilstatistisch oder vollstatistisch aufgebaut sind. Auch diese sind in der Tabelle mit aufgeführt. Alle diese Polymere wurden auch für einen Einsatz in PLEDs untersucht. Wie PLEDs dargestellt werden können, ist bereits in WO 04/037887 und der darin zitierten Literatur ausführlich beschrieben.

Auch die wichtigsten Device-Eigenschaften (Farbe, Effizienz, Betriebsspannung und Lebensdauer) sind in der Tabelle mit aufgeführt.
Hier wird klar ersichtlich, dass die Verwendung von alternierenden Lochleiter-Grundgerüst-Blöcken zu einer deutlichen Reduzierung der Betriebsspannung führt, abhängig von der eingebauten Menge diese Blöcke. Weiterhin ist offensichtlich, dass beispielsweise die Verwendung von Lochleiter-Homoblöcken die Effizienz und die Lebensdauer der Polymere deutlich steigert. Dabei bleibt die Emissionsfarbe der Polymere überwiegend unverändert.

**Tabelle 1:**

| | Anteil der Monomere in der Polymerisation [%] | | | | Block | | GPC^{b} | | Elektrolumineszenz^{c} | | | |
|---|---|---|---|---|---|---|---|---|---|---|---|---|
| Polymer (Typ)³ | Monom.1 | Monom.2 | Monom.3 | Monom.4 | Block | Restpolymer | M_{w} [kDa] | Mₙ [kDa] | CIE x/y^{d} | Max. Eff. [Cd/A] | U @ 100 Cd/m² [V] | LT^{e} [h] |
| **P1 (S)** | 50% **M1/M2** | 30% **M7/M8** | 10% **M9** | 10% **M19** | altern. **M2/M9** | statistisch | 993 | 200 | 0,18/0,29 | 5,60 | 3,3 | 2200 |
| **P2 (S)** | 50% **M1/M2** | 20% **M7/M8** | 20% **M9** 10% | 10% **M19** | altern. **M2/M9** | statistisch | 392 | 91 | 0,18/0,27 | 5,09 | 3,1 | 2000 |
| **P3 (S)** | 50% **M1/M2** | 30% **M7** | 10% **M11/BOR1** | 10% **M19** | Homo **M11/BOR1** | statistisch | 361 | 96 | 0,18/0,31 | 6,19 | 3,9 | 2700 |
| **P4 (S)** | 50%**M1/M2** | 30% **M7/M8** | 10% **M11^{f}/BOR1** | 10% **M19/BOR2** | Homo. **M11/BOR1** | statistisch | 304 | 78 | 0,19/0,32 | 6,31 | 4,0 | 3100 |
| **P5 (S)** | 50% **M2** | 20% **M7** | 10% **M9** | 20% **M21** | altern. **M2/M9** | teilstatistisch | 296 | 72 | 0,31/0,58 | 11,43 | 2,8 | >5000 |
| **P6 (S)** | 50% **M1/M2** | 20% **M7** | 10% **M11^{f}/BOR1** | 20% **M21** | Homo. **M11/BOR1** | statistisch | 296 (484) | 70 (121) | 0,32/0,58 0,35/0,58 | 14,73 | 3,1 | >7500 |
| **P7 (S)** | 50% **M2** | 35% **M12** | 10% **M9** | 5% **M23** | altern. **M2/M9** | teilstatistisch | 149 | 53 | 0,67/0,33 | 2,25 | 3,1 | >8000 |
| **P8 (S)** | 50% **M2** | 30% **M7** | 10% **M19** | 10% **M9** | altern. **M2/M19** | teilstatistisch | 374 | 125 | 0,19/0,33 | 4,5 | 3,8 | 2000 |
| **P9 (S)** | 50% **M2** | 30% **M7** | 10% **M19** | 10% **M9** | altern. **M2/M19**+ altern. **M2/M9** | teilstatistisch | 456 | 107 | 0,18/0,31 | 5,6 | 3,32 | 3600 |
| **P9 (S)** | 50% **M2** | 30% **M7** | 10% **M19** | 10% **M9** | altern. **M2/M19/ M2/M9** | teilstatistisch | 445 | 125 | 0,18/0,30 | 5,4 | 3,23 | 2700 |
| **V1 (S)** | 50% **M1/M2** | 30% **M7/M8** | 10% **M9** | 10% **M19** | --- | statistisch | 666 | 167 | 0,18/0,29 | 4,84 | 3,9 | 1800 |
| **V2 (S)** | 50% **M1/M2** | 20% **M7/M8** | 20% **M9** | 10% **M19** | --- | statistisch | 561 | 148 | 0,18/0,27 | 4,98 | 3,7 | 1500 |
| **V3 (S)** | 50% **M2** | 30% **M7** | 0% **M11^{f}** | 10% **M19** | --- | teilstatistisch | 696 | 228 | 0,17/0,26 | 5,45 | 3,8 | 1300 |
| **V4 (S)** | 50% **M1/M2** | 30% **M7/M8** | 10% **M11/EM1** | 10% **M19/EM3** | --- | statistisch | 509 | 126 | 0,21/0,33 | 5,94 | 3,9 | 1400 |
| **V5 (S)** | 50% **M2** | 20% **M7** | 10% **M9** | 20% **M21** | --- | teilstatistisch | 497 | 140 | 0,29/0,57 | 10,22 | 3,2 | >5000 |
| **V6 (S)** | 50% **M2** | 20% **M7** | 10 % **M11** | 20% **M21** | --- | teilstatistisch | 624 | 159 | 0.31/0.58 | 8.97 | 2.9 | 2500 |
| **V7 (S)** | 50%**M2** | 35% **M12** | 10**% M9** | 5%**M23** | --- | teilstatistisch | 472 | 63 | 0.68/0.32 | 1.92 | 3.5 | >5000 |

| | | | | | | | | | | | | |
|---|---|---|---|---|---|---|---|---|---|---|---|---|
| ^{a} S = Durch Suzuki-Polymerisation hergestellt (vgl. Bsp. P1), ^{b} GPC Messungen THF; 1 mL/min, Plgel 10µm Mixed-B 2 x 300 x 7.5 mm², 35 °C, RI Detektion gegen Polystyrol geeicht ^{c} Zur Herstellung der Polymer LEDs, siehe Teil C. ^{d} CIE-Koordinaten: Chromatizitäts-Koordinaten der Commission Internationale de l'Eclairage von 1931. ^{e} Die angegebene Lebensdauer bezieht sich auf den so genannten LT50-Wert, d. h. die Zeit, die verstreicht, bis die entsprechende PLED nur noch 50 % der Anfangshelligkeit aufweist; die Werte wurden extrapoliert auf eine Anfangshelligkeit von 100 Cd/m . ^{f} Das Monomer M11 ist am nicht-bromierten Phenylring in para-Position zum Stickstoff mit einer *sec*-Butylgruppe substituiert. | | | | | | | | | | | | |

## Patentansprüche

1. Konjugierte Copolymere, enthaltend mindestens eine blockartige Struktur, welche ein Homoblock oder ein Block mit einer alternierenden Monomersequenz ist und die mindestens eine der folgenden Eigenschaften a - e aufweist:
a) Ladungstransportblock (für Loch- oder Elektronentransport),
b) Ladungsinjektionsblock (für Injektion positiver oder negativer Ladungen),
c) emittierender Block,
d) Block, der den Übergang von Singulett- zu Triplett-Excitonen erleichtert, oder
e) Polymergrundgerüstblock,
wobei diese blockartigen Strukturen durch statistische Copolymerabschnitte, in denen die Sequenz aller Bausteine durch die bei der Polymerisation vorhandenen statistischen Gesetzmäßigkeiten gegeben ist, verknüpft sind oder
wobei sie durch teilstatistische Copolymerabschnitte, in denen die Anordnung einer der Wiederholeinheiten definiert ist, während die anderen Wiederholeinheiten statistisch angeordnet sind, verknüpft sind, **dadurch gekennzeichnet, dass** die statistischen oder teilstatistischen Copolymerabschnitte aus mindestens vier unterschiedlichen Monomeren aufgebaut sind.

2. Polymere gemäß Anspruch 1, **dadurch gekennzeichnet, dass** es sich bei den Blöcken um Homoblöcke handelt.

3. Polymere gemäß Anspruch 1 oder 2, **dadurch gekennzeichnet, dass** es sich bei den Blöcken um alternierende Blöcke handelt.

4. Polymere gemäß einem oder mehreren der Ansprüche 1 bis 3, **dadurch gekennzeichnet, dass** die Blöcke die Lochinjektion bzw. den Lochtransport, die Elektroneninjektion bzw. den Elektronentransport, den Übergang von so genannten Singulett-Excitonen zu Triplett-Excitonen, die Lichtemission oder mehrere dieser Eigenschaften gleichzeitig beeinflussen.

5. Polymere gemäß einem oder mehreren der Ansprüche 1 bis 4, **dadurch gekennzeichnet, dass** mindestens eine Blocksorte Lochleiter-Homoblöcke sind.

6. Polymere gemäß einem oder mehreren des Ansprüche 1 bis 4, **dadurch gekennzeichnet, dass** mindestens eine Blocksorte alternierende Lochleiter-Grundgerüst-Blöcke sind.

7. Polymere gemäß einem oder mehreren der Ansprüche 1 bis 6, **dadurch gekennzeichnet, dass** mindestens eine Blocksorte Emitter-Homoblöcke sind.

8. Polymere gemäß einem oder mehreren der Ansprüche 1 bis 6, **dadurch gekennzeichnet, dass** mindestens eine Blocksorte alternierende Emitter-Grundgerüst-Blöcke sind.

9. Polymere gemäß einem oder mehreren der Ansprüche 1 bis 8, **dadurch gekennzeichnet, dass** der Anteil der Monomere, die in Blöcken vorliegen, mindestens 10 mol% beträgt.

10. Polymere gemäß einem oder mehreren der Ansprüche 1 bis 9, **dadurch gekennzeichnet, dass** das Molekulargewicht M_{w} der Blöcke zwischen 10³ und 3·10⁵ g/mol liegt.

11. Polymere gemäß einem oder mehreren der Ansprüche 1 bis 10, **dadurch gekennzeichnet, dass** der Anteil der Monomere, die in statistischen bzw. teilstatistischen Abschnitten vorliegen, mindestens 10 mol% beträgt.

12. Polymere gemäß einem oder mehreren der Ansprüche 1 bis 11, **dadurch gekennzeichnet, dass** in den statistischen oder teilstatistischen Polymerabschnitten im Durchschnitt mindestens 5 Wiederholeinheiten enthalten sind.

13. Polymere gemäß einem oder mehreren der Ansprüche 1 bis 12, **dadurch gekennzeichnet, dass** das Polymer Strukturelemente aus den Gruppen meta-oder para-Phenylene, 1,4-Naphthylene, 9,10-Anthracenylene, 2,7-Phenanthrenylene, 2,7-(9,10-Dihydro)phenanthrenylene, 1,6- bzw. 2,7- bzw. 4,9-Pyrene oder 2,7-Tetrahydropyrene, Oxadiazolylene, 2,5-Thiophenylene, 2,5-Pyrrolylene, 2,5-Furanylene, 2,5-Pyridylene, 2,5-Pyrimidinylene, 3,6- bzw. 2,7-Carbazolylene, 5,8-Chinolinylene, Fluorene, Spiro-9,9'-bifluorene oder Indenofluorene enthält.

14. Polymere gemäß Anspruch 13, **dadurch gekennzeichnet, dass** das Polymer Strukturelemente aus den Gruppen der Spiro-9,9'-bifluorene, Fluorene, 2,7-(9,10-Dihydro)phenanthrenylene und/oder Indenofluorene enthält.

15. Polymere gemäß einem oder mehreren der Ansprüche 1 bis 14, **dadurch gekennzeichnet, dass** das Polymer Struktureinheiten enthält, die die Ladungsinjektion bzw. den Ladungstransport beeinflussen.

16. Polymere gemäß Anspruch 15, **dadurch gekennzeichnet, dass** diese Struktureinheiten aus der Klasse der Triarylamine, Oxadiazole, Pyridine, Pyrimidine, Pyrazine oder Chinoline ausgewählt sind.

17. Polymere gemäß einem oder mehreren der Ansprüche 1 bis 16, **dadurch gekennzeichnet, dass** das Polymer Struktureinheiten enthält, die die Farbe der Emission verschieben.

18. Polymere gemäß Anspruch 17, **dadurch gekennzeichnet, dass** die Strukturelemente aus den Gruppen Arylenvinylen- oder Arylenacetylen-Strukturen, wie substituierte oder unsubstituierte Stilbenyle, Tolanyle, Bisstyrylarylene, Bis(arylacetylen)-arylene oder größere aromatische Einheiten, wie Chrysene, Naphthacene, Pentacene, Perylene oder Coronene, oder heterocyclischen Einheiten, wie Thiophen oder 2,1,3-Benzothiadiazol, ausgewählt sind.

19. Polymere gemäß einem oder mehreren der Ansprüche 1 bis 18, **dadurch gekennzeichnet, dass** Strukturelemente vorhanden sind, welche einen Transfer von so genannten Singulett-Excitonen zu Triplett-Excitonen ermöglichen und die aus dem Triplettzustand Licht emittieren.

20. Blends, enthaltend ein oder mehrere Polymere gemäß einem oder mehreren der Ansprüche 1 bis 19.

21. Lösungen, enthaltend ein oder mehrere Polymere oder Blends gemäß einem oder mehreren der Ansprüche 1 bis 20, in einem oder mehreren Lösemitteln.

22. Verwendung eines Polymers oder Blends gemäß einem oder mehreren der Ansprüche 1 bis 20 in polymeren Leuchtdioden (PLEDs), organischen integrierten Schaltungen (O-ICs), in organischen Feld-Effekt-Transistoren (OFETs), in organischen Dünnfilmtransistoren (OTFTs), in organischen Solarzellen (O-SCs), organischen Laserdioden (O-Laser) oder in der nicht-linearen Optik.

23. Elektronisches Bauteil, umfassend eine oder mehrere aktive Schichten, wobei mindestens eine dieser aktiven Schichten ein oder mehrere Polymere oder Blends gemäß einem oder mehreren der Ansprüche 1 bis 20 enthält.

24. Elektronisches Bauteil (Device) gemäß Anspruch 23, **dadurch gekennzeichnet, dass** es sich um eine polymere Leuchtdiode (PLED), eine organische integrierte Schaltung (O-IC), einen organischen Feld-Effekt-Transistor (OFET), einen organischen Dünnfilmtransistor (OTFT), eine organische Solarzelle (O-SCs), eine organische Laserdiode (O-Laser) oder eine Vorrichtung zur nicht-linearen Optik handelt.

## Claims

1. Conjugated copolymers, containing at least one block-like structure which is a homoblock or a block having an alternating monomer sequence and has at least one of the following properties a-e:
a) charge-transport block (for hole or electron transport),
b) charge-injection block (for injection of positive or negative charges),
c) emitting block,
d) block which simplifies the transfer from singlet to triplet excitons, or
e) polymer backbone block,
where these block-like structures are linked by random copolymer sections in which the sequence of all units is determined by the random laws present during the polymerisation, or where they are linked by partially random copolymer sections in which the arrangement of one of the recurring units is defined, while the other recurring units are in a random arrangement, **characterised in that** the random or partially random copolymer sections are built up from at least four different monomers.

2. Polymers according to Claim 1, **characterised in that** the blocks are homoblocks.

3. Polymers according to Claim 1 or 2, **characterised in that** the blocks are alternating blocks.

4. Polymers according to one or more of Claims 1 to 3, **characterised in that** the blocks simultaneously influence hole injection or hole transport, electron injection or electron transport, transfer from so-called singlet excitons to triplet excitons, light emission or a plurality of these properties.

5. Polymers according to one or more of Claims 1 to 4, **characterised in that** at least one block type are hole conductor homoblocks.

6. Polymers according to one or more of Claims 1 to 4, **characterised in that** at least one block type are alternating hole conductor backbone blocks.

7. Polymers according to one or more of Claims 1 to 6, **characterised in that** at least one block type are emitter homoblocks.

8. Polymers according to one or more of Claims 1 to 6, **characterised in that** at least one block type are alternating emitter backbone blocks.

9. Polymers according to one or more of Claims 1 to 8, **characterised in that** the proportion of the monomers which are present in blocks is at least 10 mol%.

10. Polymers according to one or more of Claims 1 to 9, **characterised in that** the molecular weight M_{w} of the blocks is between 10³ and 3·10⁵ g/mol.

11. Polymers according to one or more of Claims 1 to 10, **characterised in that** the proportion of the monomers which are present in random or partially random sections is at least 10 mol%.

12. Polymers according to one or more of Claims 1 to 11, **characterised in that** on average at least 5 recurring units are present in the random or partially random polymer sections.

13. Polymers according to one or more of Claims 1 to 12, **characterised in that** the polymer contains structural elements from the groups meta- or para-phenylenes, 1,4-naphthylenes, 9,10-anthracenylenes, 2,7-phenanthrenylenes, 2,7-(9,10-dihydro)phenanthrenylenes, 1,6- or 2,7- or 4,9-pyrenes or 2,7-tetrahydropyrenes, oxadiazolylenes, 2,5-thiophenylenes, 2,5-pyrrolylenes, 2,5-furanylenes, 2,5-pyridylenes, 2,5-pyrimidinylenes, 3,6- or 2,7-carbazolylenes, 5,8-quinolinylenes, fluorenes, spiro-9,9'-bifluorenes or indenofluorenes.

14. Polymers according to Claim 13, **characterised in that** the polymer contains structural elements from the groups of the spiro-9,9'-bifluorenes, fluorenes, 2,7-(9,10-dihydro)phenanthrenylenes and/or indenofluorenes.

15. Polymers according to one or more of Claims 1 to 14, **characterised in that** the polymer contains structural units which influence the charge injection or charge transport.

16. Polymers according to Claim 15, **characterised in that** these structural units are selected from the class of the triarylamines, oxadiazoles, pyridines, pyrimidines, pyrazines or quinolines.

17. Polymers according to one or more of Claims 1 to 16, **characterised in that** the polymer contains structural units which shift the colour of the emission.

18. Polymers according to Claim 17, **characterised in that** the structural elements are selected from the groups arylenevinylene or aryleneacetylene structures, such as substituted or unsubstituted stilbenyls, tolanyls, bisstyrylarylenes, bis-(arylacetylene)arylenes or larger aromatic units, such as chrysenes, naphthacenes, pentacenes, perylenes or coronenes, or heterocyclic units, such as thiophene or 2,1,3-benzothiadiazole.

19. Polymers according to one or more of Claims 1 to 18, **characterised in that** structural elements are present which facilitate transfer from so-called singlet excitons to triplet excitons and emit light from the triplet state.

20. Blends comprising one or more polymers according to one or more of Claims 1 to 19.

21. Solutions comprising one or more polymers or blends according to one or more of Claims 1 to 20 in one or more solvents.

22. Use of a polymer or blend according to one or more of Claims 1 to 20 in polymeric light-emitting diodes (PLEDs), organic integrated circuits (O-ICs), in organic field-effect transistors (OFETs), in organic thin-film transistors (OTFTs), in organic solar cells (O-SCs), organic laser diodes (O-lasers) or in non-linear optics.

23. Electronic component comprising one or more active layers, where at least one of these active layers comprises one or more polymers or blends according to one or more of Claims 1 to 20.

24. Electronic component (device) according to Claim 23, **characterised in that** it is a polymeric light-emitting diode (PLED), an organic integrated circuit (O-IC), an organic field-effect transistor (OFET), an organic thin-film transistor (OTFT), an organic solar cell (O-SC), an organic laser diode (O-laser) or a device for non-linear optics.

## Revendications

1. Copolymères conjugués, contenant au moins une structure en forme de bloc qui est un homobloc ou un bloc comportant une séquence de monomères alternés et qui présente au moins l'une des propriétés qui suivent a-e :
a) bloc de transport de charges (pour un transport de trous ou d'électrons),
b) bloc d'injection de charges (pour l'injection de charges positives ou négatives),
c) bloc d'émission,
d) bloc qui simplifie le transfert depuis des excitons singlets jusqu'à des excitons triplets, ou
e) bloc d'ossature polymérique,
où ces structures en forme de bloc sont liées par des sections de copolymères aléatoires où la séquence de toutes les unités est déterminée par les lois aléatoires présentes pendant la polymérisation, ou où ces structures sont liées par des sections de copolymères partiellement aléatoires où l'agencement de l'une des unités récurrentes est défini, tandis que les autres unités récurrentes sont selon un agencement aléatoire, **caractérisé en ce que** les sections de copolymères aléatoires ou partiellement aléatoires sont construites à partir d'au moins quatre monomères différents.

2. Polymères selon la revendication 1, **caractérisés en ce que** les blocs sont des homoblocs.

3. Polymères selon la revendication 1 ou 2, **caractérisés en ce que** les blocs sont des blocs alternés.

4. Polymères selon une ou plusieurs des revendications 1 à 3, **caractérisés en ce que** les blocs influencent de façon simultanée une injection de trous ou un transport de trous, une injection d'électrons ou un transport d'électrons, un transfert depuis ce que l'on appelle des excitons singlets jusqu'à des excitons triplets, une émission de lumière ou une pluralité de ces propriétés.

5. Polymères selon une ou plusieurs des revendications 1 à 4, **caractérisés en ce qu'**au moins un type de blocs sont des homoblocs conducteurs de trous.

6. Polymères selon une ou plusieurs des revendications 1 à 4, **caractérisés en ce qu'**au moins un type de blocs sont des blocs d'ossature conducteurs de trous alternés.

7. Polymères selon une ou plusieurs des revendications 1 à 6, **caractérisés en ce qu'**au moins un type de blocs sont des homoblocs émetteurs.

8. Polymères selon une ou plusieurs des revendications 1 à 6, **caractérisés en ce qu'**au moins un type de blocs sont des blocs d'ossature émetteurs alternés.

9. Polymères selon une ou plusieurs des revendications 1 à 8, **caractérisés en ce que** la proportion des monomères qui sont présents dans des blocs est d'au moins 10 mol%.

10. Polymères selon une où plusieurs des revendications 1 à 9, **caractérisés en ce que** le poids moléculaire M_{w} des blocs est entre 10³ et 3·10⁵ g/mol

11. Polymères selon une ou plusieurs des revendications 1 à 10, **caractérisés en ce que** la proportion des monomères qui sont présents dans des sections aléatoires
ou partiellement aléatoires est d'au moins 10 mol%.

12. Polymères selon une ou plusieurs des revendications 1 à 11, **caractérisés en ce qu'**en moyenne, au moins 5 unités récurrentes sont présentes dans les sections de polymères aléatoires ou partiellement aléatoires.

13. Polymères selon une ou plusieurs des revendications 1 à 12, **caractérisés en ce que** le polymère contient des éléments structurels issus des groupes méta- ou para-phénylènes, 1,4-naphthylènes, 9,10-anthracénylènes, 2,7-phénanthrénylènes, 2,7-(9,10-dihydro)phénanthrénylènes, 1,6- ou 2,7- ou 4,9-pyrènes ou 2,7-tétrahydropyrènes, oxadiazolylènes, 2,5-thiophénylènes, 2,5-pyrrolylènes, 2,5-furanylènes, 2,5-pyridylénes, 2,5-pyrimidinylènes, 3,6- ou 2,7-carbazolylènes, 5,8-quinolinylènes, fluorènes, spiro-9,9'-bifluorènes ou indénofluorènes.

14. Polymères selon la revendication 13, **caractérisés en ce que** le polymère contient des éléments structurels issus des groupes spiro-9,9'-bifluorènes, fluorènes, 2,7-(9,10-dihydro)phénanthrényiènes et/ou indénofluorènes.

15. Polymères selon une ou plusieurs des revendications 1 à 14, **caractérisés en ce que** le polymère contient des unités structurelles qui influencent l'injection de charges ou le transport de charges.

16. Polymères selon la revendication 15, **caractérisés en ce que** ces unités structurelles sont choisies parmi la classe des triarylamines, des oxadiazoles, des pyridines, des pyrimidines, des pyrazines ou des quinolines.

17. Polymères selon une ou plusieurs des revendications 1 à 16, **caractérisés en ce que** le polymère contient des unités structurelles qui décalent la couleur de l'émission.

18. Polymères selon la revendication 17, **caractérisés en ce que** les éléments structurels sont choisis parmi les groupes structures arylènevinylène ou arylène-acétylène, telles que des stylbényles, des tolanyles, des bisstyrylarylènes, des bis(arylacétylène)arylènes ou des unités aromatiques plus grandes substitués ou non substitués, telles que chrysènes, naphtacènes, pentacènes, pérylènes ou coronènes, ou des unités hétérocycliques, telles que thiophène ou 2,1,3-benzothiadiazole.

19. Polymères selon une ou plusieurs des revendications 1 à 18, **caractérisés en ce que** des éléments structurels sont présents, lesquels facilitent un transfert depuis ce que l'on appelle des excitons singlets jusqu'à des excitons triplets et émettent de la lumière depuis l'état triplet.

20. Mélanges comprenant un ou plusieurs polymères selon une ou plusieurs des revendications 1 à 19.

21. Solutions comprenant un ou plusieurs polymères ou mélanges selon une ou plusieurs des revendications 1 à 20 dans un ou plusieurs solvants.

22. Utilisation d'un polymère ou mélange selon une ou plusieurs des revendications 1 à 20 dans des diodes émettrices de lumière polymériques (PLED), dans des circuits intégrés organiques (O-IC), dans des transistors à effet de champ organiques (OFET), dans des transistors à film mince organiques (OTFT), dans des cellules solaires organiques (O-SC), dans des diodes laser organiques (O-laser)
ou dans des optiques non linéaires.

23. Composant électronique comprenant une ou plusieurs couches actives, où au moins l'une de ces couches actives comprend un ou plusieurs polymères ou mélanges selon une ou plusieurs des revendications 1 à 20.

24. Composant (dispositif) électronique selon la revendication 23, **caractérisé en ce qu'**il s'agit d'une diode émettrice de lumière polymériques (PLED), d'un circuit intégré organique (O-IC), d'un transistor à effet de champ organique (OFET), d'un transistor à film mince organique (OTFT), d'une cellule solaire organique (O-SC), d'une diode laser organique (O-laser) ou d'un dispositif pour des optiques non linéaires.
